(19) Europäisches Patentamt
European Patent Office
Office européen des brevets

(11) **EP 2 214 212 A1**

(12) **EUROPEAN PATENT APPLICATION**
published in accordance with Art. 153(4) EPC

(43) Date of publication:
**04.08.2010 Bulletin 2010/31**

(51) Int Cl.:
*H01L 31/0224* (2006.01)    *H01B 1/22* (2006.01)

(21) Application number: **08851454.2**

(22) Date of filing: **20.11.2008**

(86) International application number:
**PCT/JP2008/071094**

(87) International publication number:
**WO 2009/066719 (28.05.2009 Gazette 2009/22)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **21.11.2007  JP 2007301271**

(71) Applicant: **TOYO ALUMINIUM KABUSHIKI KAISHA**
**Chuo-ku**
**Osaka-shi**
**Osaka 541-0056 (JP)**

(72) Inventors:
• **KIKUCHI, Ken**
**Osaka-shi**
**Osaka 541-0056 (JP)**
• **IKEDA, Masakazu**
**Osaka-shi**
**Osaka 541-0056 (JP)**

• **OHKUMA, Takashi**
**Osaka-shi**
**Osaka 541-0056 (JP)**
• **KATOH, Haruzo**
**Osaka-shi**
**Osaka 541-0056 (JP)**
• **MIYAZAWA, Yoshiteru**
**Osaka-shi**
**Osaka 541-0056 (JP)**
• **OCHI, Yutaka**
**Osaka-shi**
**Osaka 541-0056 (JP)**
• **MATSUMURA, Ken**
**Osaka-shi**
**Osaka 541-0056 (JP)**
• **ISHIBASHI, Naoaki**
**Osaka-shi**
**Osaka 541-0056 (JP)**

(74) Representative: **Grünecker, Kinkeldey, Stockmair & Schwanhäusser**
**Anwaltssozietät**
**Leopoldstrasse 4**
**80802 München (DE)**

(54) **PASTE COMPOSITION AND SOLAR BATTERY ELEMENT**

(57)    Provided are a paste composition capable of achieving a BSF effect which is equivalent to or greater than a conventionally achieved BSF effect even when used in either case where a thin back surface electrode layer is formed on a thick silicon semiconductor substrate or case where a thin back surface electrode layer is formed on a thin silicon semiconductor substrate and, when used in a case where a thin back surface electrode layer is formed on a thin silicon semiconductor substrate, not only capable of achieving a BSF effect which is equivalent to or greater than a conventionally achieved BSF effect, but also capable of more suppressing deformation of the silicon semiconductor substrate after being fired, than in a case where the conventional paste composition is used in order to form a thin back surface electrode layer; and a solar cell element comprising an electrode formed by using the paste composition. The paste composition comprises aluminum powder as electrically conductive powder and the aluminum powder includes flaky aluminum particles. The solar cell element comprises a back surface electrode (8) formed by applying the above-mentioned paste composition onto a back surface of a p-type silicon semiconductor substrate (1) and thereafter, firing a resultant.

**(Cont. next page)**

EP 2 214 212 A1

FIG.1

**Description**

TECHNICAL FIELD

The present invention relates generally to paste compositions and solar cell elements and, more particularly, to a paste composition used when an electrode is formed on a back surface of a silicon semiconductor substrate constituting a crystalline silicon solar cell, and to a solar cell element in which a back surface electrode is formed by using the paste composition.

BACKGROUND ART

As an electronic component having an electrode formed on a back surface of a p-type silicon semiconductor substrate, solar cell elements disclosed in Japanese Patent Application Laid-Open Publication No. 2000-90734 (Patent Document 1) and Japanese Patent Application Laid-Open Publication No. 2004-134775 (Patent Document 2) have been known.

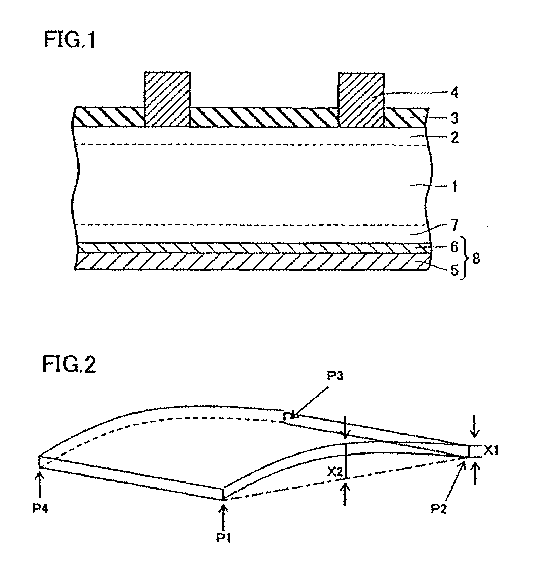

Fig. 1 is a schematic view showing a general sectional structure of a solar cell element.

As shown in Fig. 1, the solar cell element is structured by using a p-type silicon semiconductor substrate 1 whose thickness is 200 to 300 $\mu$m. On a side of a light receiving surface of the p-type silicon semiconductor substrate 1, an n-type impurity layer 2 whose thickness is 0.3 to 0.6 $\mu$m, and an antireflection film 3 and grid electrodes 4, which are on the n-type impurity layer 2, are formed.

On a side of a back surface of the p-type silicon semiconductor substrate 1, an aluminum electrode layer 5 is formed. The formation of the aluminum electrode layer 5 is conducted through applying a paste composition including aluminum powder composed of aluminum particles each having substantially spherical shape, a glass frit, and an organic vehicle by employing screen printing or the like; drying; and thereafter, firing the resultant for a short period of time at a temperature greater than or equal to 660°C (melting point of aluminum). During the firing, the aluminum is diffused into the p-type silicon semiconductor substrate 1, whereby an Al-Si alloy layer 6 is formed between the aluminum electrode layer 5 and the p-type silicon semiconductor substrate 1 and concurrently, a $p^+$ layer 7 is formed as an impurity layer resulting from diffusion of aluminum atoms. The presence of the $p^+$ layer 7 prevents recombination of electrons, and therefore, a BSF (Back Surface Field) effect which enhances an efficiency of collecting generated carriers can be obtained.

For example, as disclosed in Japanese Patent Application Laid-Open Publication No. 5-129640 (Patent Document 3), a solar cell element in which a back surface electrode 8 including an aluminum electrode layer 5 and an Al-Si alloy layer 6 is removed by using acid or the like and a collecting electrode layer is newly formed by using a silver paste or the like has been put into practical use. However, since disposal of the acid used for removing the back surface electrode 8 is required, for example, a problem that the disposal makes a process complicated arises. In recent years, in order to avoid such a problem, many solar cell elements have been structured with the back surface electrode 8 left as it is and utilized as a collecting electrode.

Although in a solar cell element in which a back surface electrode is formed through applying the conventional paste composition including aluminum powder, which is composed of the aluminum particles each having the substantially spherical shape, onto a back surface of a p-type silicon semiconductor substrate and through firing the resultant, a certain efficiency of collecting generated carriers has been obtained, it has been required to further enhance the desired BSF effect in order to increase a conversion efficiency.

Patent Document 1: Japanese Patent Application Laid-Open Publication No. 2000-90734
Patent Document 2: Japanese Patent Application Laid-Open Publication No. 2004-134775
Patent Document 3: Japanese Patent Application Laid-Open Publication No. 5-129640

DISCLOSURE OF THE INVENTION

Problems to be solved by the invention

In the meantime, in order to solve a problem of a shortage of a silicon material and to reduce costs in manufacturing solar cells, rendering the p-type silicon semiconductor substrate thinner has been examined these days.

In particular, there have been growing concerns over the global environment in recent years, the importance of photovoltaic power generation has become recognized worldwide, a great number of firms have joined the field of the photovoltaic power generation, and boosts in the production of solar cells have followed one after another. Therefore, it has become difficult to procure p-type silicon semiconductor substrates which are materials of solar cell elements. In order to cope with the above-mentioned situation and to secure volumes of the production of the solar cells, it has been attempted to render the p-type silicon semiconductor substrate further thinner so as to have a thickness of 160 $\mu$m, than

the conventional thickness in a range of 200 $\mu$m to 220 $\mu$m which has so far been the mainstream.

However, in a case where the conventional paste composition including the aluminum powder composed of the aluminum particles each having the substantially spherical shape is applied to the p-type silicon semiconductor substrate having the thinner thickness and the resultant is fired, after firing the paste composition, a side of a back surface having an electrode layer formed thereon is deformed in a concave manner due to a difference between a thermal expansion coefficient of the silicon of the p-type silicon semiconductor substrate and a thermal expansion coefficient of the aluminum, thereby deforming and bowing the p-type silicon semiconductor substrate. In addition, also in a case where the paste composition is applied to the p-type silicon semiconductor substrate having the thinner thickness with an application amount of the paste composition increased in order to enhance the BSF effect and the resultant is fired, after firing the paste composition, the side of the back surface having the electrode layer formed thereon is deformed in the concave manner due to the difference between the thermal expansion coefficient of the silicon of the p-type silicon semiconductor substrate and the thermal expansion coefficient of the aluminum, thereby deforming and bowing the p-type silicon semiconductor substrate. Consequently, fractures or the like are caused in a process of manufacturing the solar cells, thereby resulting in a problem that manufacturing yields of the solar cells are reduced.

There is a method to solve this problem of the bowing, in which an application amount of the paste composition is decreased and the back surface electrode layer is rendered thinner. However, when the application amount of the paste composition is decreased, an amount of the aluminum diffused from the back surface of the p-type silicon semiconductor substrate to an inside thereof becomes insufficient. As a result, a desired BSF effect cannot be achieved, thereby incurring a problem that properties of the solar cell are reduced.

Furthermore, in a situation where the thickness of the p-type silicon semiconductor substrate has been extremely thinner, even if the application amount of the paste composition is drastically decreased, there also arises a problem that a certain degree of the bowing of the p-type silicon semiconductor substrate is caused.

Moreover, in a case where a content of the aluminum powder included in the paste composition is decreased without decreasing the application amount of the paste composition, an electric resistance of the back surface electrode after being fired is increased, a conversion efficiency is reduced, and there also arises a problem that a certain degree of the bowing thereof is caused.

Therefore, one object of the present invention is to solve the above-mentioned problems and to provide a paste composition capable of, when used in order to form a thin back surface electrode layer on a comparatively thick silicon semiconductor substrate as is conventional, sufficiently achieving a BSF effect which is approximately equivalent or more than equivalent to that achieved in a case where the conventional paste composition including aluminum powder composed of aluminum particles each having a substantially spherical shape is used in order to form a thick back surface electrode layer.

Further another object of the present invention is to provide a paste composition, when used in order to form a thin back surface electrode layer on a thin silicon semiconductor substrate, not only capable of achieving a BSF effect which is approximately equivalent or more than equivalent to that achieved in a case where the conventional paste composition including the aluminum powder composed of the aluminum particles each having a substantially spherical shape is used in order to form a thick back surface electrode layer, but also capable of more drastically suppressing deformation of the silicon semiconductor substrate after being fired, than in a case where the conventional paste composition including the aluminum powder composed of the aluminum particles each having the substantially spherical shape is used in order to form the thin back surface electrode layer.

Still another object of the present invention is to provide a solar cell element comprising a back surface electrode layer formed by using the above-mentioned paste composition.

Means for solving the problems

In order to solve the problems of the conventional art, the present inventors have repeated eager researches. As a result, the present inventors found that the above-mentioned objects can be achieved by using aluminum powder including flaky aluminum particles as aluminum powder included in a paste composition. Based on the findings, the paste composition according to the present invention has the following features.

The paste composition according to the present invention is used for forming an electrode on a back surface of a p-type silicon semiconductor substrate constituting a crystalline silicon solar cell and comprises aluminum powder as electrically conductive powder, and the aluminum powder includes flaky aluminum particles. Here, the flaky aluminum particles are particles, each of which has a platy, flaky or flat contour, or includes at least a platy contour portion or at least a flat contour portion.

Preferably, in the paste composition according the present invention, a content of the flaky aluminum particles is greater than or equal to 10% by mass and less than or equal to 50% by mass.

In addition, preferably, in the paste composition according the present invention, an average particle size of the flaky aluminum particles is greater than or equal to 3 $\mu$m and less than or equal to 60 $\mu$m.

More preferably, in the paste composition according the present invention, an average aspect ratio is greater than or equal to 30 and less than or equal to 600, the aspect ratio being a ratio of the average particle size of the flaky aluminum particles to an average thickness of the flaky aluminum particles.

Furthermore, preferably, the paste composition according the present invention further comprises an organic vehicle and/or a glass frit.

A solar cell element according to the present invention comprises an electrode formed by applying the paste composition having any of the above-described features onto a back surface of a p-type silicon semiconductor substrate and thereafter, firing the resultant.

EFFECT OF THE INVENTION

As described above, according to the present invention, by using aluminum powder including flaky aluminum particles as aluminum powder included in a paste composition, even when the paste composition of the present invention is used in either case where a thin back surface electrode layer is formed on a comparatively thick silicon semiconductor substrate and a thin back surface electrode layer is formed on a thin silicon semiconductor substrate, it is made possible to sufficiently achieve at least a BSF effect which is approximately equivalent or more than equivalent to that achieved in a case where the conventional paste composition including aluminum powder composed of aluminum particles each having a substantially spherical shape is used in order to form a thick back surface electrode layer. In addition, when the paste composition of the present invention is used in order to form a thin back surface electrode layer on a thin silicon semiconductor substrate, it is made possible not only to achieve a BSF effect which is approximately equivalent or more than equivalent to that achieved in a case where the conventional paste composition including the aluminum powder composed of the aluminum particles each having the substantially spherical shape is used in order to form a thick back surface electrode layer, but also to more drastically suppress deformation of the silicon semiconductor substrate after being fired, than in a case where the conventional paste composition including the aluminum powder composed of the aluminum particles each having the substantially spherical shape is used in order to form the thin back surface electrode layer.

BRIEF DESCRIPTION OF THE DRAWINGS

Fig. 1 is a schematic view showing a general sectional structure of a solar cell element to which the present invention as one embodiment is applied.
Fig. 2 is a schematic view showing a method for measuring bow amounts of p-type silicon semiconductor substrates of examples and comparison examples, each of which has an aluminum electrode layer formed therein as a back surface electrode layer and has been fired.

EXPLANATION OF REFERENCE NUMERALS

1: p-type silicon semiconductor substrate, 2: n-type impurity layer, 3: antireflection film, 4: grid electrode, 5: aluminum electrode layer, 6: Al-Si alloy layer, 7: p$^+$ layer, 8: back surface electrode.

BEST MODE FOR CARRYING OUT THE INVENTION

The present inventors focused attention on a relationship between properties of a solar cell element and aluminum powder included in a paste composition and in particular, on a shape of each aluminum particle and discovered that the properties of the solar cell element can be enhanced by using aluminum powder including aluminum particles each having a specific contour as the aluminum powder included in the paste composition.

The paste composition according to the present invention comprises the aluminum powder as electrically conductive powder, the aluminum powder including flaky aluminum particles. Conventionally, in a paste composition used for forming an aluminum electrode layer on a back surface of a p-type silicon semiconductor substrate, aluminum powder composed of aluminum particles each having a spherical shape or a near-spherical shape is used as the aluminum powder included in the paste composition.

In the present invention, by using the aluminum powder composed of the flaky aluminum particles, even when a thin back surface electrode layer is formed on the p-type silicon semiconductor substrate, it is made possible to achieve a BSF effect which is approximately equivalent or more than equivalent to that achieved in a case where a thick back surface electrode layer is formed by using the conventional paste composition including the aluminum powder composed of the aluminum particles each having substantially spherical shape.

As disclosed in Japanese Patent Application Laid-Open Publication No. 2000-90734 (Patent Document 1), it has been generally known that by rendering a back surface electrode layer thin, an amount of caused bowing of the p-type silicon semiconductor substrate is decreased. However, a conversion efficiency is reduced.

In contrast to this, in a case where the paste composition according to the present invention is used in order to form a thin back surface electrode layer on a thin silicon semiconductor substrate, it is made possible not only to achieve a BSF effect which is approximately equivalent or more than equivalent to that achieved in a case where the conventional paste composition including the aluminum powder composed of the aluminum particles each having the substantially spherical shape is used in order to form a thick back surface electrode layer, but also to more drastically suppress deformation of the silicon semiconductor substrate after being fired, than in a case where the conventional paste composition including the aluminum powder composed of the aluminum particles each having the substantially spherical shape is used in order to form a thin back surface electrode layer.

It is inferred that in a case where the paste composition according to the present invention is used, action that light energy is trapped is exerted, though the reason for this is not exactly known. In a case where a back surface electrode layer is formed by using the conventional paste composition, the back surface electrode layer after being fired has a matted grayish appearance. In contrast to this, in a case where a back surface electrode layer is formed by using the paste composition according to the present invention, the back surface electrode layer after being fired has a light-reflecting silvery appearance. Therefore, it is inferred that in the present invention, the back surface electrode layer after being fired serves as a reflecting layer which reflects light entering an inside of the silicon semiconductor substrate from a surface thereof, whereby the action that the light energy is trapped inside the silicon semiconductor substrate is exerted. Accordingly, it is inferred that since due to this action, a loss of the light energy is decreased, even in a case where a thin back surface electrode layer is formed, it is made possible to maintain a conversion efficiency which is approximately equivalent or more than equivalent to that maintained in a case where the conventional paste composition including the aluminum powder composed of the aluminum particles each having the substantially spherical shape is used in order to form a thick back surface electrode layer.

It is not required that all the aluminum particles of which the aluminum powder included in the paste composition according to the present invention is composed are flaky. When the aluminum powder contained in the paste composition includes the flaky aluminum particles, the above-described effect can be attained. When aluminum powder composed of a mixture of the flaky aluminum particles and the conventionally used aluminum particles each having the spherical shape or the near-spherical shape is included in a paste composition, the above-described effect can be attained.

The flaky aluminum particles may be produced by employing any method. For example, an aluminum thin film is formed on a surface of a plastic film through deposition, is exfoliated from the surface of the plastic film, and thereafter, is milled; or aluminum particles are obtained by employing the conventional heretofore known atomization method and are milled in the presence of an organic solvent by using a ball mill, whereby the flaky aluminum particles may be produced.

In general, onto surfaces of the flaky aluminum particles obtained through milling by using the above-mentioned ball mill, a grinding aid, for example, such as a higher fatty acid has adhered. In the present invention, the flaky aluminum particles having surfaces onto which the grinding aid has adhered may be used, and flaky aluminum particles having surfaces from which the grinding aid has been removed may be used. Even by using any of the above-mentioned flaky aluminum particles, the above-described effect can be attained.

In addition, it is preferable that a content of the flaky aluminum particles included in the paste composition is greater than or equal to 10% by mass and less than or equal to 50 % by mass, and it is further preferable that the content of the flaky aluminum particles included in the paste composition is greater than or equal to 15% by mass and less than or equal to 30 % by mass. When the content of the flaky aluminum particles is within the above-mentioned range, the paste composition including the flaky aluminum particles is excellent in terms of application properties and printing properties when applied onto the p-type silicon semiconductor substrate.

Because the conventional paste composition includes an extremely high content of the aluminum powder composed of the aluminum particles each having the substantially spherical shape, application of the paste composition is conducted through screen printing in general. However, since the paste composition according to the present invention allows a reduction in a content of the aluminum powder, which includes the flaky aluminum particles, contained in the paste composition, an application method is not limited to the screen printing method and the application thereof can be conducted through, for example, a spraying method. When the application thereof can be conducted through the spraying method, a mass production is enabled as compared with a case where the application is conducted through the screen printing method, and it is likely to allow a drastic reduction in labor required for the application.

In addition, a content of the aluminum powder included in the conventional paste composition is approximately 70% by mass, which constitutes a considerably high percentage of the paste composition as mentioned above. This is because in a case where the content of the aluminum powder is, for example, less than or equal to 60% by mass, an electric resistance of a back surface electrode layer formed through applying the paste composition onto a back surface of a p-type silicon semiconductor substrate and firing the resultant is increased, thereby incurring a reduction in properties of a solar cell element and specifically, a reduction in a conversion efficiency.

In contrast to this, in the present invention, despite the content of the flaky aluminum particles in the paste composition, which is less than or equal to 60% by mass, the above-mentioned problem does not arise.

Though the reason for this is not known exactly, it is inferred that a thickness of each of the flaky aluminum particles is thinner than that of each of the aluminum particles each having the substantially spherical shape, the flaky aluminum particles are susceptible to a thermal effect when fired, and as a result, reactivity with the silicon substrate is improved and diffusion of the aluminum is promoted.

It is preferable that an average particle size of the flaky aluminum particles is greater than or equal to 3 $\mu$m and less than or equal to 60 $\mu$m, and it is further preferable that the average particle size of the flaky aluminum particles is greater than or equal to 7 $\mu$m and less than or equal to 30 $\mu$m. When the average particle size of the flaky aluminum particles is within the above-mentioned range, the paste composition including the flaky aluminum particles is excellent in terms of application properties and printing properties when applied onto the p-type silicon semiconductor substrate. Note that the average particle size of the flaky aluminum particles can be measured by employing laser diffractometry.

In addition, it is preferable that an average aspect ratio which is a ratio of the average particle size of the flaky aluminum particles to an average thickness thereof is greater than or equal to 30 and less than or equal to 600, and it is further preferable that the average aspect ratio is greater than or equal to 70 and less than or equal to 300. When the average aspect ratio of the flaky aluminum particles is within the above-mentioned range, the paste composition including the flaky aluminum particles is excellent in terms of application properties and printing properties when applied onto the p-type silicon semiconductor substrate. Note that the average aspect ratio is calculated as a ratio between the average particle size measured by employing the laser diffractometry and the average thickness (average particle size [$\mu$m]/ average thickness [$\mu$m]).

The average thickness is obtained, as described in Japanese Patent Application Laid-Open Publication No. 06-200191 and WO2004/026970, through a calculation method in which a water surface diffusion area of the flaky aluminum particles is measured and substituted in specific equations, and specifically, the calculation method is as described below.

A mass w (g) of the flaky aluminum particles after being cleaned by using acetone and being dried and a coverage area A (cm$^2$) resulting when the flaky aluminum particles are evenly floated on a water surface are measured, and a WCA (the water covering area) is calculated by using the following Equation 1. Next, a value of the WCA is substituted in the following Equation 2, thereby calculating the average thickness of the flaky aluminum particles.

$$\text{Equation 1: WCA } (\text{cm}^2/\text{g}) = A \ (\text{cm}^2)/w \ (\text{g})$$

$$\text{Equation 2: average thickness } (\mu\text{m}) = 10^4/(2.5 \ (\text{g/cm}^3) \times \text{WCA})$$

The above-mentioned method of calculating the average thickness is described in, for example, Aluminum Paint and Powder, 3rd Edition, Pages 16 to 22, written by J. D. Edeards and R. I. Wray and published by Reinhold Publishing Corp, New York (1955), and the like.

In a case where a saturated higher fatty acid such as a stearic acid has not adhered to the surfaces of the flaky aluminum particles or an unsaturated higher fatty acid, not the saturated higher fatty acid, has adhered to the surfaces of the flaky aluminum particles, a leafing process is conducted, the coverage area A is measured, and the WCA is calculated, as described in Japanese Patent Application Laid-Open Publication No. 06-200191.

It is preferable that the paste composition according to the present invention further includes an organic vehicle. Components of the included organic vehicle are not particularly limited, and a resin such as an ethyl cellulose based resin and an alkyd based resin and a solvent such as a glycol ether based solvent and a terpineol based solvent can be used. It is preferable that a content of the organic vehicle is greater than or equal to 5% by mass and less than or equal to 20% by mass. When the content of the organic vehicle is within the above-mentioned range, the paste composition including the flaky aluminum particles is excellent in terms of application properties and printing properties when applied onto the p-type silicon semiconductor substrate.

Furthermore, the paste composition according to the present invention may include a glass frit. It is preferable that a content of the glass frit is greater than or equal to 0.5% by mass and less than or equal to 5% by mass. The glass frit has an effect of enhancing adhesion properties of the aluminum electrode layer after being fired. However, if the content of the glass frit exceeds 5% by mass, segregation of glass occurs, whereby a resistance of the aluminum electrode layer as the back surface electrode layer is likely to be increased. Although it is only required for an average particle size of the glass frit not to adversely affect the effect of the present invention and the average particle size of the glass frit is not particularly limited, a glass frit whose average particle size is approximately 1 through 4 $\mu$m can be favorably used ordinarily.

The glass frit contained in the paste composition according to the present invention and in particular, composition and contents of components thereof are not limited, and ordinarily, a glass frit whose softening point is less than or equal to a firing temperature is used. Ordinarily, as the glass frit, a $B_2O_3$-$SiO_2$-$Bi_2O_3$ based glass frit, a $B_2O_3$-$SiO_2$-ZnO based glass frit, a $B_2O_3$-$SiO_2$-PbO based glass frit, or the like in addition to a $SiO_2$-$Bi_2O_3$-PbO based glass frit can be used.

In addition, the paste composition according to the present invention can include a variety of substances, provided that such substances do not impede the effect of the present invention. For example, the paste composition according to the present invention is appropriately mixed with other components such as a heretofore known resin, a viscosity modifier, a surface conditioner, an anti-settling agent, and an anti-foaming agent and can be prepared as the paste composition.

As a method for manufacturing the paste composition according to the present invention, for example, a method in which the respective components are stirred and mixed by using a heretofore known agitator, a method in which the respective components are kneaded by using a kneader such as a roll mill, or the like can be employed. However, the method for manufacturing the paste composition according to the present invention is not limited to the above-mentioned methods.

EXAMPLES

Hereinafter, examples of the present invention will be described.

Kinds of aluminum powder A and B shown in Table 1 and a glass frit shown in Table 2 were prepared, and these were used as raw powder materials of examples 1 through 4 and comparison examples 1 through 4. The aluminum powder A was prepared through milling atomized powder by using a ball mill such that aluminum particles had a predetermined average particle size and average aspect ratio. As the aluminum powder B, atomized powder was used as it was. Values of an average particle size of flaky aluminum particles constituting the aluminum powder A (average particle size of the aluminum powder A shown in Table 1), an average particle size of the aluminum powder B (average particle size of the aluminum powder B shown in Table 1) each having a substantially spherical shape, and an average particle size of the glass frit (average particle size shown in Table 2) were measured by employing laser diffractometry. The average particle sizes of the kinds of aluminum powder A and B shown in Table 1 were measured by employing the laser diffractometry and using Microtrac X100 (a measuring instrument produced by NIKKISO CO., LTD.). In addition, an average thickness of the flaky aluminum particles constituting the aluminum powder A was measured as described above by employing the calculation method in which the water surface diffusion coverage area of the flaky aluminum particles was measured and substituted in the specific equations. By using these measurement values, as shown in Table 1, an average aspect ratio of the aluminum powder A was calculated.

Next, each of the kinds of aluminum powder A and B shown in Table 1 was mixed with the glass frit shown in Table 2 in each proportion shown in Table 3, and further added therein is an organic vehicle wherein ethyl cellulose whose content with respect to each of the paste compositions was 8% by mass was dissolved in a glycol ether based organic solvent, whereby various paste compositions (each total content 100% by mass) were prepared.

Specifically, by adding each of the kinds of the aluminum powder A and B and the glass frit to the organic vehicle wherein the ethyl cellulose was dissolved in the glycol ether based organic solvent and mixing them by means of a well-known mixer, the paste compositions of the examples 1 through 4 and the comparison examples 1 through 4 were prepared.

On the other hand, as shown in Fig. 1, on a light receiving surface of a silicon wafer as a p-type silicon semiconductor substrate 1 which has a pn junction formed therein and has a thickness of 160 $\mu$m or 200 $\mu$m and dimensions of 125 mm × 125 mm, a grid electrode 4 made of Ag was formed.

By employing a screen printing method, a paste composition of each of the examples 1 through 4 and the comparison examples 1 through 4 was applied on a back surface of the above-mentioned silicon wafer with a printing pressure of 0.1 kg/cm$^2$ and an application amount after drying was adjusted to be 0.2 g/wafer (250-mesh screen printing plate used) or 1.5 g/wafer (160-mesh screen printing plate used), thereby forming application layers of the respective paste compositions.

The application layers formed as described above were dried at a temperature of 100°C and thereafter, fired in an infrared firing furnace at a maximum temperature of 830°C, and thereby, back surface electrode layers were formed, thus preparing test samples of the examples 1 through 4 and the comparison examples 1 through 4.

A bow (deformation) amount of each of the test samples prepared as described above was measured by a laser displacement meter (a display unit: LK-GD500 and a sensor: LK-G85, both manufactured by KEYENCE Corporation). A method of measuring the bow is as described below.

First, each of the silicon wafers was placed on a flat surface such that the back surface (concave surface) of each of the test samples, that is, a surface of each of the silicon wafers, to which each of the paste compositions was applied, faces downward. As shown in Fig. 2, a side spanning between P1 and P4 of each of the silicon wafer, placed on the flat surface, and a side spanning between P2 and P3 thereof are in contact with the flat surface, whereas a side spanning between P1 and P2 thereof and a side spanning between P3 and P4 thereof are bulging upward above the flat surface due to the deformation caused by the bow.

Based on this, the measurement was conducted while the laser displacement meter was being moved on the side spanning between P1 and P2. As values measured by using the laser displacement meter, a minimum displacement value (X1) indicates a thickness of each of the silicon wafer (including a thickness of the back surface electrode layer) since a position of P2 (or P1) is in contact with the flat surface, and a maximum displacement value (X2) indicates a total value of the thickness of each of the silicon wafer and the bow (deformation) amount. Based on this, a bow amount of each of the test samples was calculated from the maximum displacement value (X2) and the minimum displacement value (X1) of the values measured with the laser displacement meter by using the following equation.

$$\text{Bow (mm) amount} = \text{Maximum displacement value (X2)} - \text{Minimum displacement value (X1)}$$

Next, in the same way as described above, the measurement was conducted while the laser displacement meter was being moved on the side spanning between P3 and P4, opposite to the side spanning between P1 and P2 and thereby, a bow amount of each of the test samples was calculated by using the above-mentioned equation.

As described above, an average value of a value of the bow amount, obtained by the measurement on the side spanning between P1 and P2, and a value of the bow amount, obtained by the measurement on the side spanning between P3 and P4, was calculated as a value of the bow amount of each of the test samples.

In addition, conversion efficiencies (Eff) of solar cell elements of the test samples of the examples 1 through 4 and the comparison examples 1 through 4, prepared as described above, were respectively measured by using a solar simulator (WXS-155S-10, manufactured by WACOM ELECTRIC CO., LTD.) under conditions of a temperature of 25°C and AM1.5G spectrum.

A result of the above-described measurement is shown in Table 3.

[Table 1]

| Aluminum Powder | Average Particle Size ($\mu$m) | Average Aspect Ratio |
|---|---|---|
| A | 20 | 200 |
| B | 5 | - |

[Table 2]

| | Components | Average Particle Size ($\mu$m) |
|---|---|---|
| Glass Frit | $SiO_2$-$Bi_2O_3$-PbO Based | 2 |

[Table 3]

| | Aluminum Powder | | Glass Frit (% by mass) | Organic Vehicle (% by mass) | Wafer Thickness ($\mu$m) | Application Amount (g/ wafer) | Bow (mm) | Conversion Efficiency (%) |
|---|---|---|---|---|---|---|---|---|
| | A (% by mass) | B (% by mass) | | | | | | |
| Example 1 | 20 | - | 3 | 8 | 200 | 0.2 | 0.1 | 15.0 |
| Example 2 | 20 | - | 3 | 8 | 160 | 0.2 | 0.2 | 14.5 |
| Example 3 | 15 | - | 3 | 8 | 160 | 0.2 | 0.2 | 13.5 |
| Example 4 | 30 | - | 3 | 8 | 160 | 0.2 | 0.2 | 14.5 |

(continued)

| | Aluminum Powder | | Glass Frit (% by mass) | Organic Vehicle (% by mass) | Wafer Thickness (μm) | Application Amount (g/ wafer) | Bow (mm) | Conversion Efficiency (%) |
|---|---|---|---|---|---|---|---|---|
| | A (% by mass) | B (% by mass) | | | | | | |
| Comparison Example 1 | - | 70 | 3 | 8 | 200 | 1.5 | 1.5 | 15.0 |
| Comparison Example 2 | - | 70 | 3 | 8 | 160 | 1.5 | 3.0 | 14.5 |
| Comparison Example 3 | - | 70 | 3 | 8 | 200 | 0.2 | 1.0 | 7.0 |
| Comparison Example 4 | - | 20 | 3 | 8 | 200 | 1.5 | 0.8 | 8.0 |

It is seen from the result shown in Table 3 that in a case where the paste composition according to the present invention was used in order to form a thin back surface electrode layer on a comparatively thick silicon semiconductor substrate (having a thickness of 200 μm) (Example 1), it was made possible to sufficiently achieve a BSF effect (conversion efficiency) which was substantially equivalent to that achieved in a case where the conventional paste composition was used in order to form a thick back surface electrode layer (Comparison Example 1); and in a case where the paste composition according to the present invention was used in order to form a thin back surface electrode layer on a comparatively thin silicon semiconductor substrate(having a thickness of 160 μm) (Examples 2 through 4), it was made possible not only to achieve a BSF effect which was approximately equivalent or substantially equivalent to that achieved in a case where the conventional paste composition was used in order to form a thick back surface electrode layer on a comparatively thin silicon semiconductor substrate (having a thickness of 160 μm) (Comparison Example 2) but also to more drastically suppress deformation of the silicon semiconductor substrate after being fired, than in a case where the conventional paste composition was used in order to form a thin back surface electrode layer on a comparatively thick silicon semiconductor substrate (having a thickness of 200 μm) (Comparison Example 3). In addition, in a case where the conventional paste composition was used in order to form a thin back surface electrode layer (Comparison Example 3) and in a case where the conventional paste composition including a small amount of the aluminum powder composed of the aluminum particles each having the substantially spherical shape was used in order to form a thick back surface electrode layer (Comparison Example 4), merely a low BSF effect was obtained.

The described embodiment and examples are to be considered in all respects only as illustrative and not restrictive. It is intended that the scope of the invention is, therefore, indicated by the appended claims rather than the foregoing description of the embodiment and examples and that all modifications and variations coming within the meaning and equivalency range of the appended claims are embraced within their scope.

INDUSTRIAL APPLICABILITY

According to the present invention, even when a paste composition of the present invention using aluminum powder, as aluminum powder included in the paste composition, including flaky aluminum particles is used in either case where a thin back surface electrode layer is formed on a comparatively thick silicon semiconductor substrate and a thin back surface electrode layer is formed on a thin silicon semiconductor substrate, it is made possible to sufficiently achieve at least a BSF effect which is approximately equivalent or more than equivalent to that achieved in a case where the conventional paste composition including aluminum powder composed of aluminum particles each having a substantially spherical shape is used in order to form a thick back surface electrode layer. In addition, when the paste composition of the present invention is used in order to form a thin back surface electrode layer on a thin silicon semiconductor substrate, it is made possible not only to achieve a BSF effect which is approximately equivalent or more than equivalent to that achieved in a case where the conventional paste composition including the aluminum powder composed of the aluminum particles each having the substantially spherical shape is used in order to form a thick back surface electrode layer, but also to more drastically suppress deformation of the silicon semiconductor substrate after being fired, than in a case where the conventional paste composition including the aluminum powder composed of the aluminum particles each having the substantially spherical shape is used in order to form the thin back surface electrode layer.

**Claims**

1. A paste composition used for forming an electrode (8) on a back surface of a p-type silicon semiconductor substrate (1) constituting a crystalline silicon solar cell, the paste composition comprising aluminum powder as electrically conductive powder, wherein
the aluminum powder includes flaky aluminum particles.

2. The paste composition according to claim 1, wherein a content of the flaky aluminum particles is greater than or equal to 10% by mass and less than or equal to 50% by mass.

3. The paste composition according to claim 1, wherein an average particle size of the flaky aluminum particles is greater than or equal to 3 $\mu$m and less than or equal to 60 $\mu$m.

4. The paste composition according to claim 1, wherein an average aspect ratio is greater than or equal to 30 and less than or equal to 600, the aspect ratio being a ratio of an average particle size of the flaky aluminum particles to an average thickness of the flaky aluminum particles.

5. The paste composition according to claim 1, further comprising an organic vehicle and/or a glass frit.

6. A solar cell element comprising an electrode (8) formed by applying the paste composition according to claim 1 onto a back surface of a p-type silicon semiconductor substrate (1) and thereafter, firing a resultant.

FIG.1

FIG.2

| INTERNATIONAL SEARCH REPORT | International application No. |
|---|---|
| | PCT/JP2008/071094 |

| A. CLASSIFICATION OF SUBJECT MATTER |
|---|
| *H01L31/0224*(2006.01)i, *H01B1/22*(2006.01)i |

According to International Patent Classification (IPC) or to both national classification and IPC

| B. FIELDS SEARCHED |
|---|
| Minimum documentation searched (classification system followed by classification symbols) |
| H01L31/00-31/20, H01B1/00-1/24 |

Documentation searched other than minimum documentation to the extent that such documents are included in the fields searched

| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| X | JP 2006-313744 A (E.I. Du Pont De Nemours & Co.), 16 November, 2006 (16.11.06), & EP 1713094 A2  & KR 10-2006-0108552 A & US 2006/0231803 A1  & CN 101055776 A | 1-6 |
| X | JP 2005-510836 A (Ferro Corp.), 21 April, 2005 (21.04.05), & WO 2003/045584 A1  & CA 2467690 A & US 2004/0046154 A1  & EP 1448316 A & CN 1592659 A | 1-6 |
| X | JP 2007-224191 A (Sanyo Electric Co., Ltd.), 06 September, 2007 (06.09.07), (Family: none) | 1-6 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered  to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 21 January, 2009 (21.01.09) | 03 February, 2009 (03.02.09) |
| Name and mailing address of the ISA/ | Authorized officer |
| Japanese Patent Office | |
| Facsimile No. | Telephone No. |

Form PCT/ISA/210 (second sheet) (April 2007)

**INTERNATIONAL SEARCH REPORT**

International application No.

PCT/JP2008/071094

C (Continuation).　DOCUMENTS CONSIDERED TO BE RELEVANT

| Category* | Citation of document, with indication, where appropriate, of the relevant passages | Relevant to claim No. |
|---|---|---|
| X | JP 2002-76398 A  (Sanyo Electric Co., Ltd.),<br>15 March, 2002 (15.03.02),<br>(Family: none) | 1-6 |
| Y | JP 2000-90734 A  (Murata Mfg. Co., Ltd.),<br>31 March, 2000 (31.03.00),<br>(Family: none) | 1-6 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000090734 A
- JP 2004134775 A
- JP 5129640 A
- JP 6200191 A
- WO 2004026970 A

**Non-patent literature cited in the description**

- **J. D. Edeards ; R. I. Wray.** Aluminum Paint and Powder. Reinhold Publishing Corp, 1955, 16-22